Europäisches Patentamt

(19) European Patent Office

Office européen des brevets

(11) Veröffentlichungsnummer: **0 007 016**
**B1**

(12) **EUROPÄISCHE PATENTSCHRIFT**

(45) Veröffentlichungstag der Patentschrift:
12.08.81

(51) Int. Cl.³: **G 11 C 19/28**, H 01 L 27/10

(21) Anmeldenummer: **79102010.0**

(22) Anmeldetag: **18.06.79**

(54) Spannungs-Ladungswandler.

(30) Priorität: **17.07.78 US 925150**

(43) Veröffentlichungstag der Anmeldung:
**23.01.80 Patentblatt 80/2**

(45) Bekanntmachung des Hinweises auf die Patenterteilung:
**12.08.81 Patentblatt 81/32**

(84) Benannte Vertragsstaaten:
**DE FR GB**

(56) Entgegenhaltungen:
1. US-A-3 760 202 (R.C.A.)
2. US-A-3 925 805 (HUGHES)
3. US-A-3 944 990 (INTEL)
4. US-A-3 958 210
5. US-A-4 085 459
6. US-A-4 092 734
7. US-A-4 139 910
8. US-A-4 144 588
9. CHARGE TRANSFER DEVICES, Academic Press, 1975, Seiten 236—301, New York, USA
C. H. SEQUIN et al.: »Digital Memories«
10. IBM TECHNICAL DISCLOSURE BULLETIN, Vol. 20, Nr. 8, Januar 1978, Seiten 3011—3013, Armonk, USA

(73) Patentinhaber: **International Business Machines Corporation, Armonk, N.Y. 10504 (US)**

(72) Erfinder: **Heller, Lawrence Griffith, 25 Wildwood Drive, Essex Junction, VT 05452 (US)**

(74) Vertreter: **Böhmer, Hans Erich, Dipl.-Ing., Schönaicher Strasse 220, D-7030 Böblingen (DE)**

H. S. LEE: »Converter for CCD Multilevel Shift Registers«
11. IEEE JOURNAL OF SOLID-STATE CIRCUITS, Vol. SC-11, Nr. 1, Februar 1976, Seiten 4—10, New York, USA
L. M. TERMAN et al.: »Overview of CCD Memory«
12. IEEE JOURNAL OF SOLID-STATE CIRCUITS, Vol. SC-10, Nr. 5, Oktober 1975, Seiten 273—280, New York, USA
S. D. ROSENBAUM et al.: »8192-Bit Block Addressable CCD Memory«
13. IEEE JOURNAL OF SOLID-STATE, Vol. SC-13, Nr. 5, Oktober 1978, Seiten 688—693, New York, USA
M. YAMADA et al.: »A New Multilevel Storage Structure for High Density CCD Memory«

## Spannungs-Ladungswandler

Die Erfindung betrifft Spannungs-Ladungswandler in ladungsgekoppelten Vorrichtungen und insbesondere einen verbesserten Wandler dieser Art zur Erzeugung von duplizierten und Teilladungspaketen an auf Abstand voneinander liegenden Speicherstellen in einen Halbleitersubstrat.

### Stand der Technik

Die Erzeugung von Ladungspaketen in mit ladungsgekoppelten Vorrichtungen arbeitenden Speichersystemen (CCD) für die Übertragung einer Ladung von einer Potentialmulde nach einer anderen ist allgemein bekannt. Ferner sind CCD-Speichersysteme unter Verwendung von mehrwertigen Signalen oder mehrwertigen Ladungen an einem vorgegebenen Speicherplatz zur Darstellung von drei oder mehr binären Informationswerten ebenfalls bekannt und sind beispielsweise in IBM Technical Disclosure Bulletin, Band 20, Nr. 8, Januar 1978, Seiten 3011 – 3013, in einem Aufsatz »Converter for CCD Multilevel Shift Registers« von H. S. Lee offenbart.

Aus der US-A-4 085 459 ist das Injizieren mehrwertiger Signale mit mindestens drei Informationsspannungspegeln in Form von elektrischen Ladungen in ein CCD-System bekannt. In dem Aufsatz von H. S. Lee sowie in IBM Technical Disclosure Bulletin, Band 20, Nr. 8, Januar 1978, Seiten 3014 – 3016, in einem weiteren Aufsatz mit dem Titel »Fractional Charge Packet Generator« von J. A. Hiltebeitel und N. G. Vogl Jr. ist ebenfalls die Erzeugung von Teilladungspaketen in der Weise offenbart, daß z. B. eine vorgegebene Ladungsmenge in einer bestimmten Potentialmulde gespeichert wird, worauf dann eine Hälfte der vorgegebenen Ladungsmenge jeweils auf die zwei benachbarten Potentialmulden übertragen wird.

Aus der der Anmelderin gehörenden US-A ist ein Verfahren und eine Vorrichtung zum Duplizieren und Wiederherstellen eines Ladungspaketes in der Weise bekannt, daß zunächst ein vorgegebenes Ladungspaket in eine erste Potentialmulde eingeführt wird, welches dann, wenn die an der dieser Potentialmulde zugeordneten Elektrode liegende Spannung abgesenkt wird, bewirkt, daß dadurch Ladungsträger einer gleich großen Ladungsmenge von einer Source-Diffusion nach einer unter einer zweiten Elektrode liegenden zweiten Potentialmulde übertragen werden. In der ebenfalls der Anmelderin gehörenden US-A-4 035 667 ist eine Eingangsschaltung für das verzerrungsarme oder verzerrungsfreie Injizieren von Ladungspaketen in ein CCD-Speichersystem auf lineare Weise beschrieben, so daß die injizierte Ladung vom Schwellenwert und der Kapazität der Eingangsschaltung unabhängig wird.

Aufgabe der vorliegenden Erfindung ist es, ein verbessertes Verfahren und eine entsprechende Vorrichtung zur Erzeugung von Ladungspaketen an auf Abstand voneinander liegenden Stellen in einem Halbleitersubstrat zu schaffen, wobei die Forderung nach möglichst gleich großen Kapazitäten entfällt. Vorzugsweise sollen die Ladungspakete an ausgewählten, voneinander auf Abstand liegenden Stellen in einem Halbleitersubstrat in der Weise erzeugt werden, daß anstelle einer Ladung eine Spannung an die ausgewählten Stellen angelegt wird, wobei parasitäre Kapazitäten die Verteilung oder die Erzeugung von Ladungspaketen an den ausgewählten Stellen nicht beeinflussen. Dabei soll die Erzeugung von Ladungspaketen unterschiedlicher Größe an ausgewählten, auf Abstand voneinander liegenden Stellen in einem Halbleitersubstrat mit relativ hohen Geschwindigkeiten vor sich gehen.

Gemäß der Erfindung wird ein Spannungs-Ladungswandler unter Verwendung einer Kondensatorschaltung zur Erzeugung ganzer Ladungspakete oder von Teilladungspaketen an ausgewählten, voneinander auf Abstand liegenden Stellen in einem Halbleitersubstrat geschaffen. Jede Leitung eines an gegenüberliegenden Seiten der Kondensatorschaltung angeschlossenen Leitungspaares wird durch eine der beiden Ladungs-Übertragungsvorrichtungen eines Paares selektiv auf eine vorbestimmte Spannung aufgeladen, wobei jede der Ladungs-Übertragungsvorrichtungen jeweils mit dem Eingang eines ersten und eines zweiten die Ladung verwertenden Systems verbunden ist. Außerdem werden dabei Spannungen eines ersten und eines zweiten Pegels an jede Leitung des Leitungspaares angelegt. Durch vorherige Aufladung der einen Leitung des Leitungspaares und durch Ändern der an der anderen Leitung des Leitungspaares liegenden Spannung von einem ersten Wert nach einem zweiten Wert wird ein erstes Ladungspaket in einer Potentialmulde eines ersten, die Ladung ausnutzenden Systems gebildet. Zum Injizieren eines Duplikats des ersten Ladungspaketes in eine Potentialmulde des zweiten Systems werden gleichartige Spannungen über der Kondensatorschaltung in bezug auf das zweite System angelegt. Soll dagegen in das zweite System ein Ladungspaket injiziert werden, das nur einen Bruchteil des ersten Ladungspakets darstellt, dann unterscheiden sich die gleichartigen Spannungen nur insofern, daß die Spannungsdifferenz zwischen der ersten und der zweiten Amplitude in einen Bruchteil geändert wird, die dem Bruchteil des gewünschten Ladungspaketes entspricht. Durch Voraufladung der an die Kondensatorschaltung angeschlossenen Leitungen werden während der Ladungsinjektion parasitäre Wirkungen unwirksam gemacht. In einer Ausführungsform der Erfindung enthält die Kondensatorschaltung einen einzigen Kondensator, der zwischen einem ersten und einem zweiten System eingeschaltet ist, während in einer zweiten Ausführungsform zwei in Reihe geschaltete Kondensatoren zwischen einem ersten und einem zweiten System eingeschaltet sind und ein verbessertes Betriebsverhalten liefern.

Die Erfindung wird nunmehr anhand von Ausführungsbeispielen in Verbindung mit den beigefügten Zeichnungen im einzelnen näher erläutert.

In den Zeichnungen zeigt

Fig. 1 ein Schaltbild einer Ausführungsform der Erfindung,

Fig. 2 eine isometrische Ansicht mit einer Teilschnittansicht einer erfindungsgemäß aufgebauten integrierten Schaltung,

Fig. 3 ein Impulsdiagramm zur Darstellung der Arbeitsweise der in Fig. 1 und 2 gezeigten Ausführungsform und

Fig. 4 eine Kondensatorschaltung, die zur Darstellung der zweiten Ausführungsform der Erfindung in Fig. 1 anstelle der dort gezeigten Kondensatorschaltung verwendet werden kann.

## Beschreibung der bevorzugten Ausführungsformen

In vielen mit Ladungsübertragung arbeitenden sogenannten CCD-Speichersystemen ist es erwünscht, an mehrfachen Stellen eines Halbleitersubstrats, unabhängig von gleich großen Kapazitäten eine Duplizierung von Ladungspaketen oder Ladungspaketen halber Größe zu erzeugen. Beispielsweise werden zur Speicherung einer binären 1 und einer binären 0 Ladungspakete Q1 und Q0 am Eingang eines CCD-Speichersystems eingegeben, während am Ausgang des Speichersystems ein Halbpegel-Ladungspaket, d. h. (Q1−Q2)/2 zur Abfühlung der binären Informationen erforderlich ist. Das Ladungspaket Q1 kann ein ganzes Paket sein, das eine vorgegebene Ladungsmenge enthält, und das Ladungspaket Q0 kann frei von jeder Ladung sein. In mehrstufigen CCD-Speichersystemen, bei denen ein Ladungspaket mehr als ein Informationsbit darstellen kann, können statt der halben Ladungspakete andere Bruchteile von Ladungspaketen erforderlich sein.

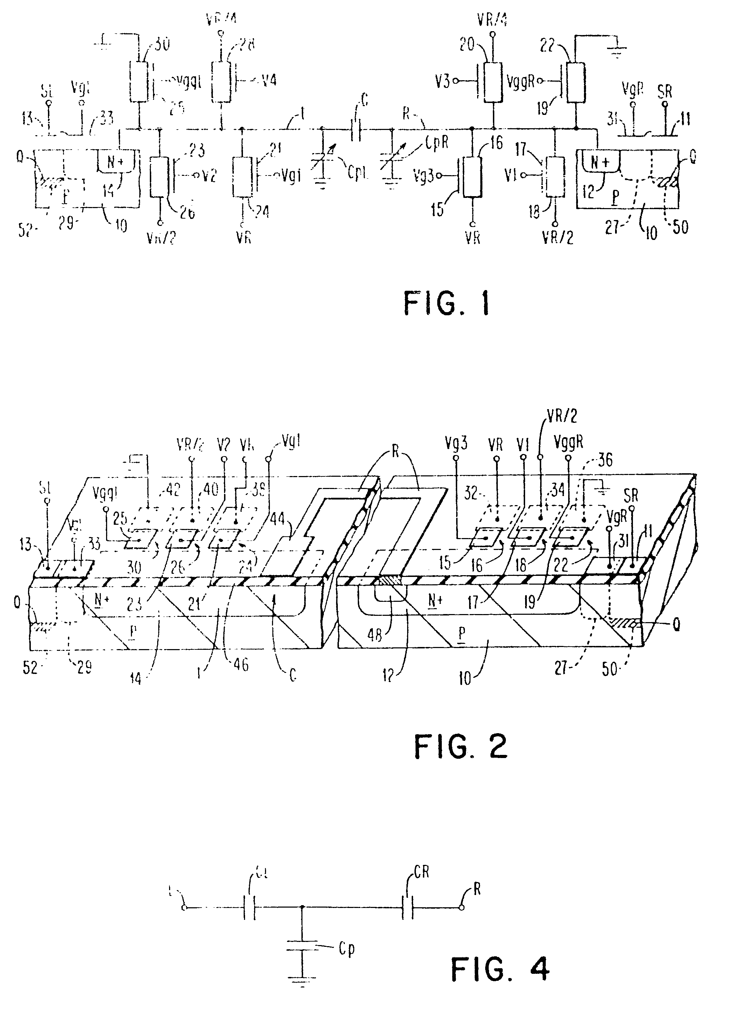

Eine Ausführungsform einer Schaltung und ein von der Forderung nach gleich großen Kapazitäten unabhängiges Verfahren zum Erzeugen von Ladungspaketen an auf Abstand voneinander liegenden Stellen eines Halbleitersubstrats gemäß der Erfindung sind in Fig. 1, 2 und 3 der Zeichnungen gezeigt. In Fig. 1 ist eine erste Stufe eines ersten CCD-Speichersystems durch eine erste Speicherelektrode 11 dargestellt, die gegenüber einem vorzugsweise aus Silicium bestehenden Halbleitersubstrat isoliert ist. Innerhalb des Halbleitersubstrats 10 ist eine erste N+-leitende Diffusionszone 12 gebildet, die Ladungsträger, genauer gesagt Elektronen, an das erste CCD-Speichersystem abgibt. Eine erste Stufe eines zweiten CCD-Speichersystems wird durch eine zweite Speicherelektrode 13 angedeutet, die gegen das Substrat 10 isoliert ist und einen Abstand von der ersten Speicherelektrode 11 aufweist. Eine zweite N+-leitende Diffusionszone 14 ist in dem Substrat 10 gebildet und erzeugt Ladungen, d. h. Elektronen für die Injektion in das zweite CCD-Speichersystem. Die Schaltung oder die Spannungs-Ladungsumwandlung gemäß der Erfindung enthält einen Kondensator C, der mit einer Elektrode über eine Leitung R an der ersten N+-leitenden Diffusionszone 12 und mit der anderen Elektrode über eine Leitung L an der zweiten N+-leitenden Diffusionszone angeschlossen ist. Die Kapazität des Kondensators C kann beispielsweise den Wert von $20 \times 10^{-15}$ Farad haben. Die erste Leitung R hat eine Streukapazität $C_{pR}$ und die zweite Leitung L hat die Streukapazität $C_{pL}$. Eine Anzahl von Bezugspotentialen VR, VR/2 und VR/4 sind über einen ersten Feldeffekttransistor 16, einen zweiten Feldeffekttransistor 18 bzw. einen dritten Feldeffekttransistor 20 an der ersten Leitung R angeschlossen, während Erdpotential über einen vierten Feldeffekttransistor 22 mit der Leitung R verbunden ist. Die gleichen Bezugspotentiale VR, Vr/2 und VR/4 sind über einen fünften Feldeffekttransistor (FET) 24, einen sechsten FET 26 bzw. einen siebten FET 28 mit der Leitung L verbunden, während Erdpotential über einen achten Feldeffekttransistor 30 an die Leitung L angeschlossen ist. Die Transistoren 16, 18, 22, 24, 26 und 30 weisen Gate-Elektroden 15, 17, 19, 21, 23 bzw. 25 auf, und das Bezugspotential VR kann 8 Volt betragen. Der als Spannungs-Ladungswandler wirkende Kondensator ist an die erste Stufe des ersten CCD-Speichersystems über die erste N+-leitende Diffusionszone durch eine Potentialmulde 27 angekoppelt, die in dem Halbleitersubstrat unter einer ersten Gate-Elektrode 31 gebildet ist. Außerdem ist der Spannungs-Ladungswandler an die Eingangsstufe des zweiten CCD-Speichersystems über die zweite N+-leitende Diffusionszone 14 durch eine unter einer zweiten Gate-Elektrode 33 liegende Potentialmulde 29 angekoppelt. Die erste Gate-Elektrode 31 und die erste N+-leitende Diffusionszone 12 bilden eine als erste Eingangstorschaltung arbeitende Diode und die zweite Gate-Elektrode 33 und die zweite N+-leitende Diffusionszone 14 bilden eine zweite als Eingangstorschaltung arbeitende Diode.

Die Schaltung gemäß Fig. 1 ist im wesentlichen in dem Halbleitersubstrat 10 in Fig. 2 als integrierte Schaltung dargestellt.

Fig. 2 ist eine isometrische Ansicht der integrierten Schaltung mit einem durch die erste und zweite N+-leitende Diffusionszone 12 bzw. 14 durchgehenden Schnitt. Wie in Fig. 2 gezeigt, ist die erste N+-leitende Diffusionszone 12 die Source-Elektrode für die Transistoren 16, 18 und 22, und die Drain-Elektrode der Transistoren 16, 18 und 22 wird durch Diffusionszonen 32, 34 bzw. 36 gebildet. Die zweite N+-leitende Diffusionszone 14 in Fig. 2 ist die Source-Elektrode für die Transistoren 24, 26 und 30, und die Drain-Elektrode der Transistoren 24, 26 und 30 ist bei 38, 40 bzw. 42 gezeigt. In dieser Ausführungsform wird die zweite $N^+$-leitende Diffusionszone 14 außerdem als die zweite Leitung L verwendet, doch können, falls erwünscht, auch andere Leitungen, wie z.B. mit Kupfer dotierte Aluminiumleiter benutzt werden. Einer der Belege des Kondensators C ist die leitende metallische Platte 44, die aus Aluminium bestehen kann, während der andere Beleg ein Teil der zwetien $N^+$-leitenden Diffusionszone 14 ist, wobei ein Dielektrikum 46, das beispielsweise aus Siliciumdioxid bestehen kann, zwischen der leitenden Platte 44 und der zweiten $N^+$-leitenden Diffusionszone 14 liegt. Die leitende Platte 44 ist mit der ersten $N^+$-leitenden Diffusionszone 12 über die erste Leitung R durch eine Kontaktdiffusion 48 verbunden, die eine hochdotierte $N^+$-leitende Diffusionszone innerhalb der ersten $N^+$-leitenden Diffusionszone 12 sein kann. Die erste und die zweite Speicherelektrode 11 bzw. 13 des ersten und zweiten CCD-Speichersystems und die erste und zweite Gate-Elektrode 31 und 33 sind von dem Halbleitersubstrat 10 durch die dielektrische Schicht 46 getrennt. Die Gate-Elektroden 15, 17, 19, 21, 23 und 25 der Transistoren 16, 18, 22, 24, 26 bzw. 30 sind ebenfalls durch die dielektrische Schicht 46 gegen das Substrat isoliert.

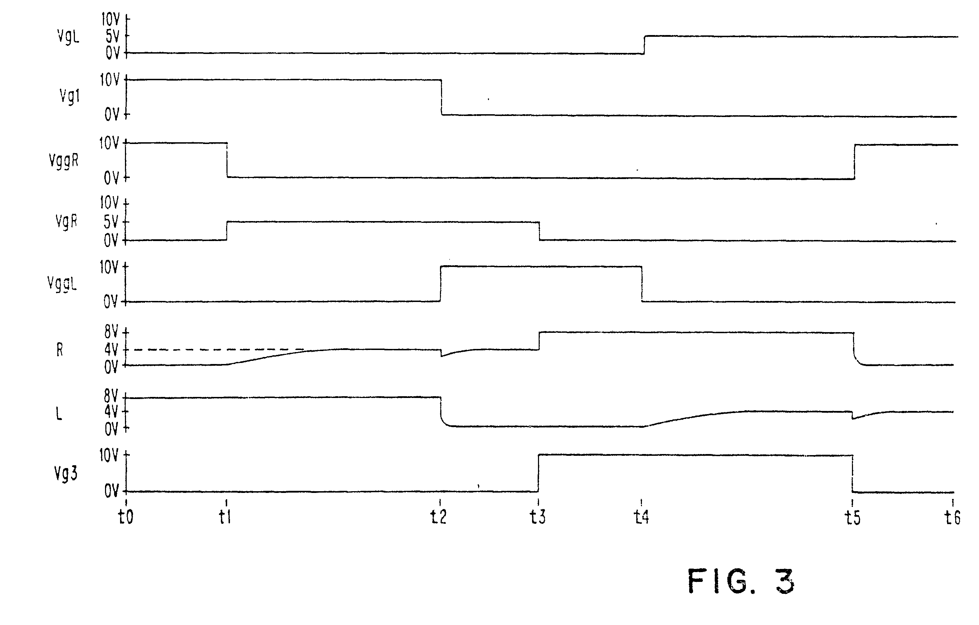

Die Arbeitsweise der in Fig. 1 und 2 dargestellten Schaltung läßt sich sowohl besser anhand des in Fig. 3 gezeigten Impulsdiagramms verstehen. Zum Injizieren einer Ladung Q in die unter der Speicherelektrode 11 der ersten Stufe des ersten CCD-Speichersystems liegende Potentialmulde 50 sei auf das Impulsdiagramm zwischen den Zeitpunkten t0 bis t3 in Fig. 3 verwiesen. Zum Zeitpunkt t0 wird durch Anlegen einer Spannung VggR an die Gate-Elektrode 19 des Transistors 22 ein Potential von 0 Volt oder Erdpotential an die erste Leitung R angelegt. Während die zweite Leitung L gleichzeitig durch Anlegen einer Spannung Vgl an die Gate-Elektrode 21 des Transistors 24 auf eine Spannung VR aufgeladen wird. Dadurch, daß an der ersten Gate-Elektrode 31 und der zweiten Gate-Elektrode 33 ein Potential von 0 Volt liegt, sind die erste und zweite Leitung R bzw. L von dem ersten bzw. zweiten CCD-Speichersystem mit den Speicherelektroden 11 und 13 isoliert. Zum Zeitpunkt t1 wird die an der ersten Gate-Elektrode 31 liegende Spannung, wie dies durch den Impuls VgR in Fig. 3 angedeutet ist, auf angenähert 5 Volt angehoben, während die an der Gate-Elektrode 19 des Transistors 22 liegende Spannung VggR auf 0 Volt abgesenkt wird, wodurch der Transistor 22 abgeschaltet wird, so daß die auf der ersten Leitung R liegende Spannung sich auf einen Wert VgR minus VtR erhöht, wobei VgR die Spannung an der ersten Gate-Elektrode 31 und VtR die Schwellenwertspannung der durch die erste Gate-Elektrode 31 und die erste $N^+$-leitende Diffusionszone 12 gebildeten, als Diode arbeitenden Eingangstorschaltung ist. Die Spannung VgR kann dabei gleich 5 Volt sein, und die Schwellenwertspannung VtR kann gleich 1 Volt sein. Wenn zum Zeitpunkt t2 die Spannung an der ersten Leitung R auf VgR minus VtR liegt, dann wird die an der Gate-Elektrode 21 des Transistors 24 liegende Spannung Vgl auf 0 herabgesetzt, wodurch der Transistor 24 gesperrt und eine Spannung VggL der Gate-Elektrode 25 des Transistors 30 zugeführt wird, wodurch die zweite Leitung L von dem Bezugspotential VR über den Transistor 30 nach Erdpotential entladen wird. Wie sich die zweite Leitung L nach Erde entlädt, wird wegen der kapazitiven Kopplung über den Kondensator C die erste Leitung R sich ebenfalls zu entladen versuchen, wie dies zum Zeitpunkt t2 auf der Zeile R angedeutet ist, wobei die Leitung R jedoch rasch wieder auf die Spannung VgR minus VtR aufgeladen wird, da die Spannung VgR immer noch an der Gate-Elektrode 31 liegt und die erste Leitung R dabei potentialfrei ist. Man erkennt aus diesem Impulsdiagramm, daß eine Ladungsmenge unter der ersten Speicherelektrode 11 in der Potentialmulde 50 gespeichert wird, da durch Verringerung der an der zweiten Leitung L liegenden Spannung von VR auf Erdpotential eine Ladungsmenge Q injiziert wird, die gleich der Kapazität des Kondensators C multipliziert mit der Spannungsdifferenz VR oder $Q = C \times VR$ ist.

Zur Erläuterung der Speicherung eines gleich großen Ladungspakets Q an einem Punkt auf dem Halbleitersubstrat 10, welcher von der ersten Speicherelektrode 11 entfernt angeordnet ist, dient das Impulsdiagramm zwischen den Zeitpunkten t3 bis t6 in Fig. 3, wobei ein Ladungspaket Q in einer Potentialmulde 52 unter der zweiten Speicherelektrode 13 des zweiten CCD-Speichersystems eingespeichert wird. Der Abstand zwischen der ersten und der zweiten Speicherelektrode 11 bzw. 13 kann dabei jeder beliebige Abstand zwischen zwei Punkten auf dem Substrat 10 sein. Zur Abspeicherung eines Ladungspakets Q in der unter der zweiten Speicherelektrode 13 liegenden Potentialmulde 52 wird die an der ersten Gate-Elektrode 31 liegende Spannung VgR auf 0 Volt abgesenkt, wodurch das erste CCD-Speichersystem von der ersten Leitung R zum Zeitpunkt t3 isoliert wird und die Spannung Vg3 wird der Gate-Elektrode 15 des Transistors 16 zugeführt, und damit liegt das Bezugspotential VR an der ersten Leitung R, während die Spannung VggL an der Gate-Elektrode 25 des Transistors 30 angelegt bleibt, so daß die zweite Leitung L auf Erdpotential gehalten wird. Zum Zeitpunkt t4 wird die Spannung VgL an die zweite Gate-Elektrode 33 angelegt, wodurch die zweite Leitung L mit dem zweiten CCD-Speichersystem verbunden ist, dessen erste Stufe durch die zweite Speicherelektrode 13 gekennzeichnet ist. Zu diesem Zeitpunkt wird die an der Gate-Elektrode 25 des Transistors 30 liegende Spannung VggL auf 0 Volt abgesenkt, so daß das Potential auf der Leitung L auf die Spannung VgL minus VtL ansteigt, wobei VgL die an der zweiten Gate-Elektrode 33 liegende Spannung und VtL die Schwellenspannung der zweiten als Eingangstorschaltung dienenden Diode ist, die aus der zweiten Gate-Elektrode 33 und der zweiten N+-leitenden Diffusionszone 14 besteht.

Die Spannung VgL ist dabei gleich der Spannung VgR und die Schwellenwertspannung VtL ist vorzugsweise gleich der Schwellenwertspannung VtR. Zum Zeitpunkt t5, wenn die zweite Leitung die Spannung VgL minus VtL angenommen hat, wird die Spannung VggR an die Gate-Elektrode 19 des Transistors 22 angelegt, wodurch die auf der ersten Leitung liegende Spannung von dem Bezugspotential VR auf Erdpotential abfällt, während die an der Gate-Elektrode 15 des Transistors 16 liegende Spannung Vg3 auf 0 Volt verringert wird. Die Verringerung der auf der ersten Leitung R liegenden Spannung hat zur Folge, daß die Spannung auf der zweiten Leitung L, die mit der ersten Leitung R über den Kondensator C gekoppelt ist, abzufallen versucht. Da die Leitung L jedoch an die Gate-Elektrode 33, an der die Spannung VgL liegt, angekoppelt ist, steigt die auf der zweiten Leitung L liegende Spannung auf den Wert VgL minus VtL an. Verringert man die an der ersten Leitung R liegende Spannung von VR auf Erdpotential, dann wird eine Ladung Q, die wiederum gleich C x VR ist, in die unter der zweiten Speicherelektrode 13 liegende Potentialmulde 52 injiziert.

Es sei darauf hingewiesen, daß wegen der Voraufladung der Leitungen L und R die Auswirkungen der Streukapazitäten CpL und CpR und die Gleichheit der Schwellenwertspannung den Ladungsbetrag nicht beeinträchtigen, der im ersten und zweiten CCD-Speichersystem abgespeichert wird. Die einzigen Faktoren, die die durch den Wandler erzeugte Ladungsmenge bestimmen, sind der Kondensator C und die Spannung VR.

Es sei darauf hingewiesen, daß die an der ersten bzw. zweiten Speicherelektrode 11 bzw. 13 liegende Spannung SR bzw. SL gleich 10 Volt oder gleich jeder anderen gewünschten Spannung sein kann, vorausgesetzt, daß jede der Spannungen SR und SL höher ist als eine Schwellenwertspannung unterhalb VgR bzw. VgL. Die Spannungen SR und SL können, falls erwünscht, ständig angelegt sein, oder sie können, falls erwünscht, impulsmäßig an die entsprechenden Speicherelektroden mindestens dann angelegt werden, wenn eine Ladung an der Gate-Elektrode 31 bzw. 33 in die Potentialmulden 27 bzw. 29 einläuft, wenn eine Ladung aufgebaut wird und wenn die erste und die zweite Leitung R bzw. L aufgeladen wird. Es sei darauf hingewiesen, daß jede sich unter der Gate-Elektrode 31 bzw. 33 in der Potentialmulde 27 bzw. 29 während der Voraufladungszeit zwischen Zeitpunkt t1 und t2 sowie Zeitpunkt t4 und t5 ansammelnde Ladung, wenn die Leitung R auf VgR minus VtR und die Leitung L auf VgL minus VtL aufgeladen wird, in üblicher Weise abgeleitet werden sollte, wie dies beispielsweise in der US-Patentschrift 4 036 667 offenbart ist, beispielsweise über eine ableitende Diode, die beispielsweise aus N+-leitendem Material bestehen kann.

Es sei ferner darauf verwiesen, daß Bruchteils-Ladungspakete, wie z. B. Q/2 oder Q/4 in einfacher Weise dadurch erzeugt weden können, daß man anstelle des Bezugspotentials VR Bezugsspannungen VR/2 oder VR/4 verwendet. Wenn man auf einer der Leitungen R oder L die Spannung von VR auf Erdpotential absenkt und damit ein Ladungspaket Q in eine erste Potentialmulde einfließen läßt und dann anschließend die auf der anderen Leitung R oder L liegende Spannung von VR/2 auf Erdpotential absenkt, dann wird ein Ladungspaket Q/2 in eine von der ersten Potentialmulde entfernt liegende zweite Potentialmulde injiziert und kann dort beispielsweise zum Abfühlen einer Ladung verwendet werden.

Wie in Fig. 1 angedeutet, kann die Spannung VR/2 über den Transistor 18 dadurch an die erste Leitung R angelegt werden, daß eine entsprechende Spannung V1 an die Gate-Elektrode 17 des Transistors 18 angelegt wird, während die Spannung VR/2 an die zweite Leitung über Transistor 26 dadurch angelegt werden kann, daß man die Spannung V2 an die Gate-Elektrode 23 des Transistors 26 anlegt. Die Spannung VR/4 zur Erzeugung des Ladungspakets Q/4 kann dadurch an die erste Leitung R angelegt werden, daß die Spannung VR/4 dadurch über den Transistor 20 angelegt wird, daß eine Spannung V3 an der Steuerelektrode des Transistors 20 liegt. Außerdem kann die Spannung VR/4 an die zweite Leitung L dadurch angelegt werden, daß durch Zuführen einer Spannung V4 an der Gate-Elektrode des Transistors 28 die Spannung VR/4 über Transistor 28 an die Leitung L angelegt wird. Aus Gründen der Klarheit sei darauf hingewiesen, daß in Fig. 2 die Transistoren 20 und 28 zum Anlegen der Spannung VR/4 nicht dargestellt sind, jedoch in gleicher Weise vorgesehen werden können, wie dies mit den Transistoren zum Anlegen der Spannungen VR und VR/2 vorgenommen wurde.

Man sieht, daß die Verteilung von genauen Gleichspannungspegeln, wie z. B. VR, VR/2 und VR/4 zur Erzeugung von gleichermaßen genauen Ladungspaketen führt, da der Kondensator C ein für die Erzeugung aller Größen von Ladungspaketen gemeinsamer Kondensator ist. Die Verteilung von mehreren Potentialstufen oder Spannungsstufen auf einem Halbleiterplättchen unterstützt ein mehrstufiges CCD-Speichersystem mit einem in üblicher Weise aufgebauten Widerstandsnetzwerk, das außerhalb des Halbleiterplättchens als Digital-Analogwandler vorgesehen sein kann. Derartige Widerstandsnetzwerke sind allgemein bekannt und können ohne Schwierigkeiten Spannungen mit weniger als 1% Genauigkeit liefern.

Es sei ferner darauf verwiesen, daß die Streukapazitäten aus dem Spannungs-Ladungswandler voraufgeladen werden, so daß die Technik gemäß der vorliegenden Erfindung sich leicht dahingehend erweitern läßt, Ladungspakete Q zur Speicherung an mehr als zwei Punkten auf einem leitenden Substrat oder Halbleiterplättchen 10 zu duplizieren. Wenn hohe Schaltgeschwindigkeit oder verbessertes Betriebsverhalten erwünscht sind, kann eine an sich bekannte Rückkopplungsschaltung für den Wandler benutzt werden, wie dies beispielsweise aus einem Aufsatz »A Fast Sample and Hold Charge-Sensing Circuit for Photo Diode Arrays« von P. G. A. Jespers u. a. in IEEE Journal of Solid-State Circuits, Band SC-12, Nr. 3, Juni 1977, Seiten 232 – 237, hervorgeht.

Obgleich gemäß Fig. 1 nur ein einziger Kondensator C in Reihe zwischen der ersten Leitung R und der zweiten Leitung L eingeschaltet ist, so sollte doch klar sein, daß eine Anzahl von in Reihe geschalteten Kondensatoren, wie die in Fig. 4 gezeigten Kondensatoren CL und CR die erste und zweite Leitung R und L miteinander verbinden können, wodurch sich ein besseres Betriebsverhalten ergibt. Bei der Anordnung gemäß Fig. 4 sollte jedoch darauf hingewiesen werden, daß die Streukapazität Cp nicht durch die Eingangstordioden mit den Gate-Elektroden 31 und 33 in Fig. 1 und 2 aufgeladen wird. Daher sind duplizierte Ladungspakete Q vom Wert der Streukapazität Cp abhängig.

Man sieht, daß die Erfindung mit Vorteil von der einfachen Übertragung von Spannungen von einem Ort an einen anderen zum Injizieren gewünschter Ladungsmengen in auf Abstand voneinander liegenden Speicherplätzen Gebrauch macht, statt eine Ladung oder ein Ladungspaket von einem Speicherplatz zu einem anderen zu transferieren, was beispielsweise die Verwendung komplexer Ladungsintegratoren erforderlich macht, wie zum Beispiel eine Eimerkettenschaltung oder einen Operationsverstärker. Außerdem muß die Länge der Leitungen L und R nicht gleich groß sein, da die Streukapazität unabhängig von ihrer Größe durch Voraufladung auf bekannte Spannungen wirkungslos gemacht werden können. Außerdem kann man das Verhältnis von Breite zu Länge (W/L) der bei diesem Wandler verwendeten Transistoren zweckmäßigerweise gleich 1 gemacht werden.

## Patentansprüche

1. Spannungs-Ladungswandler zur Erzeugung von ganzen oder Bruchteils-Ladungspaketen in jeweils einer von zwei ladungsgekoppelten Anordnungen auf einem Halbleitersubstrat, dadurch gekennzeichnet, daß jeder dieser ladungsgekoppelten Anordnungen aus einer gegen das Substrat (10) isolierten Speicherelektrode (SR, SL; 11, 13) einer über einer Potentialmulde (27, 29) isoliert angeordneten Gate-Elektrode (31, 33) und einer zum Leitungstyp des Substrats entgegengesetzt dotierten Zone (12, 14) besteht, daß jede dieser Anordnungen über eine Leitung (L, R) mit der einen bzw. der anderen Seite einer Kondensatorschaltung (C; CL, CR, CP) verbunden ist, und daß an jeder dieser Leitungen (L, R) Schalttransistoren (16, 18, 20, 22, 24, 26, 28, 30) angeschlossen sind, über die jeweils im Betrieb entweder ein Bezugspotential (VR, VR/2, VR/4) oder Erdpotential an die Leitungen anlegbar sind.

2. Spannungs-Ladungswandler nach Anspruch 1, dadurch gekennzeichnet, daß zum Anlegen des jeweiligen Bezugspotentials (VR, VR/2 bzw. VR/4) bzw. des Erdpotentials an die zugeordnete Leitung (L, R) die zugeordneten Schalttransistoren (16, 18, 20, 24, 26, 28 bzw. 22, 30) an ihren Steuerelektroden durch ein Steuerpotential (Vg1, Vg3, V1, V3, V2, V4 bzw. VggL, VggR) durchschaltbar sind.

3. Spannungs-Ladungswandler nach Anspruch 1, dadurch gekennzeichnet, daß die beiden Leitungen (L, R) unterschiedliche Länge aufweisen, wobei die eine Leitung (R) aus einem metallischen Leiter und die andere Leitung (L) aus einer Diffusionszone in dem Halbleitersubstrat (10) besteht.

4. Spannungs-Ladungswandler nach Anspruch 1, dadurch gekennzeichnet, daß die Kondensatorschaltung aus einem (C) oder mehreren (CL, CpxCR) zwischen die Leitungen (L, R) geschalteten Kondensatoren besteht.

## Claims

1. Voltage-to-charge transducer for generating whole or fractional charge packets selectively in one and the other of two charge coupled devices on a semiconductor substrate, characterized in that each of the charge coupled devices consists of a storage electrode (SR, SL; 11, 13) isolated from the substrate (10), of an isolated gate electrode (31, 33) disposed over a potential well (27, 29), and of a zone (12, 14) doped opposite to the conductivity type of the substrate, that each of the devices is connected via a line (L, R) with one side or the other side of a capacitor circuit (C; CL, CR, CP), and that to each of the lines (L, R) switching transistors (16, 18, 20, 22, 24, 26, 28, 30) are connected via which in operation a reference potential (VR, VR/2, VR/4) or ground potential can be applied to the lines.

2. Voltage-to-charge transducer as claimed in claim 1, characterized in that for applyind the reference potential (VR, VR/2, or VR/4, respectively), or the ground potential to the associated line (L, R) the associated switching transistors (16, 18, 20, 24, 26, 28, or 22, 30, respectively) can be rendered conductive by application of a control potential (Vg1, Vg3, V1, V3, V2, V4, or VggL, VggR, respectively) to their control electrodes.

3. Voltage-to-charge transducer as claimed in claim 1, characterized in that the two lines (L, R) are of different lengths, the one line (R) consisting of a metallic conductor, and the other line (L) of a zone diffused in the semiconductor substrate (10).

4. Voltage-to-charge transducer claimed in claim 1, characterized in that the capacitor circuit consists of one (C) or several (CL, CpxCR) capacitors connected between the lines (L, R).

## Revendications

1. Convertisseur tension-charge pour générer des paquets de charge entiers ou fractionnaires dans l'un de deux dispositifs à charges couplées sur un substrat semi-conducteur, caractérisé en ce que chacun de ces dispositifs à charges couplées est composé d'une électrode de mémoire (SR, SL; 11, 13) isolée du substrat (10), d'une électrode de porte (31, 33) isolée sur un puits de potentiel (27, 29), et d'une région (12, 14) de conductivité opposée à celle du substrat, en ce que chacun de ces dispositifs est connecté à travers une ligne (L, R) à l'un ou l'autre côté d'un circuit condensateur (C; CL, CR, CP), et en ce qu'à chacune de ces lignes (L, R) sont connectés des transistors de commutation (16, 18, 20, 22, 24, 26, 28, 30) à travers lesquels on peut, en fonctionnement appliquer aux lignes soit un potentiel de référence (VR, VR/2, VR/4) soit un potentiel de terre.

2. Convertisseur tension-charge selon la revendication 1 caractérisé en ce que pour appliquer le potentiel de référence respectif (VR, VR/2 ou VR/4) ou le potentiel de terre à la ligne associée (L, R), les transistors de commutation correspondants (16, 18, 20, 24, 26, 28 ou 22, 30) peuvent être commutés par un potentiel de commande à leurs électrodes de commande (Vg1, Vg3, V1, V3, V2, V4 ou VggL, VggR).

3. Convertisseur tension-charge selon la revendication 1 caractérisé en ce que les deux lignes (L, R) sont de longueurs différentes, une ligne (R) étant composée d'un conducteur métallique, et l'autre ligne (L) étant composée d'une région de diffusion dans le substrat semiconducteur (10).

4. Convertisseur tension-charge selon la revendication 1 caractérisé en ce que le circuit condensateur est composé d'un (C) ou plusieurs (CL, CpxCR) condensateurs connectés entre les lignes (L, R).

FIG. 1

FIG. 2

FIG. 4

FIG. 3